# EUROPEAN PATENT APPLICATION

(11) **EP 4 729 962 A1**
(43) Date of publication of application: **22.04.2026**
(21) Application number: 25738893.4
(22) Date of filing: 06.01.2025
(51) Int. Cl.: G01R 31/3835, G01R 31/396, G01R 19/30, G01R 19/12, G01R 19/165, B60L 58/10, H01M 10/052

(54) **APPARATUS AND METHOD FOR DIAGNOSING BATTERY**

(30) Priority: 10.01.2024 KR 20240004175
(71) Applicant: LG Energy Solution, Ltd., Seoul 07335 (KR)
(72) Inventor: CHOI, Hyun-Jun, Daejeon 34122 (KR); KIM, Tae-Hyeon, Daejeon 34122 (KR); KIM, Young-Deok, Daejeon 34122 (KR)
(74) Representative: Goddar, Heinz J.
(86) International application number: PCT/KR2025/000249
(87) International publication number: WO 2025/150819

(57) **Abstract**

An apparatus for diagnosing a battery according to the present disclosure includes a profile obtaining unit configured to obtain a differential profile representing a corresponding relationship between a voltage and a differential capacity of the battery; and a control unit configured to determine a first target peak among a plurality of peaks included in the differential profile, determine a voltage pattern of the first target peak based on a voltage profile representing a time series change of a voltage of the first target peak, and diagnose a state of the battery according to the determined voltage pattern.

## Description

### TECHNICAL FIELD

This application is based on and claims priority from Korean Patent Application No. 10-2024-0004175, filed on January 10, 2024, with the Korean Intellectual Property Office, the disclosure of which is incorporated herein in its entirety by reference.

The present disclosure relates to an apparatus and method for diagnosing a battery, and more particularly, to an apparatus and method for diagnosing a battery, which diagnoses a state of a battery in consideration of a peak behavior of a differential profile.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

### DISCLOSURE

### Technical Problem

The present disclosure is designed to solve the problems of the related art, and therefore the present disclosure is directed to providing an apparatus and method for diagnosing a battery, which diagnoses a state of a battery based on a peak behavior of a differential profile in a non-destructive manner.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a profile obtaining unit configured to obtain a differential profile representing a corresponding relationship between a voltage and a differential capacity of the battery; and a control unit configured to determine a first target peak among a plurality of peaks included in the differential profile, determine a voltage pattern of the first target peak based on a voltage profile representing a time series change of a voltage of the first target peak, and diagnose a state of the battery according to the determined voltage pattern.

The control unit may be configured to determine the voltage pattern as a voltage decrease pattern, a voltage increase pattern, or a voltage maintenance pattern.

The control unit may be configured to determine the voltage pattern as the voltage decrease pattern when a voltage change rate of the first target peak is less than a preset first reference value in the voltage profile.

The control unit may be configured to determine the voltage pattern as the voltage increase pattern when the voltage change rate of the first target peak exceeds a preset second reference value.

The control unit may be configured to determine the voltage pattern as the voltage maintenance pattern when the voltage change rate of the first target peak is greater than or equal to the first reference value and less than or equal to the second reference value.

The control unit may be configured to diagnose the state of the battery as a capacity expression state when the voltage pattern is determined as the voltage decrease pattern.

The control unit may be configured to diagnose the state of the battery as an available lithium loss state when the voltage pattern is determined as the voltage increase pattern.

When the voltage pattern is determined as the voltage maintenance pattern, the control unit may be configured to determine a second target peak among the plurality of peaks included in the differential profile, determine a differential capacity pattern of the second target peak based on a differential capacity profile representing a time series change in a differential capacity of the second target peak, and diagnose the state of the battery according to the determined differential capacity pattern.

The control unit may be configured to determine the differential capacity pattern as a differential capacity decrease pattern or a differential capacity non-decrease pattern.

The control unit may be configured to determine the differential capacity pattern as the differential capacity decrease pattern when a differential capacity change rate of the second target peak in the differential capacity profile is less than a preset third reference value.

The control unit may be configured to determine the differential capacity pattern as the differential capacity non-decrease pattern when the differential capacity change rate of the second target peak in the differential capacity profile is greater than or equal to the third reference value.

The control unit may be configured to diagnose the state of the battery as a positive electrode capacity loss state when the differential capacity pattern is determined as the differential capacity decrease pattern.

The control unit may be configured to diagnose the state of the battery as a maintenance state when the differential capacity pattern is determined as the differential capacity non-decrease pattern.

The control unit may be configured to divide the voltage profile into a plurality of sections based on a time point when the voltage pattern changes, and to diagnose the state of the battery for each of the plurality of sections.

A battery pack according to another aspect of the present disclosure may comprise the apparatus for diagnosing a battery according to one aspect of the present disclosure.

A vehicle according to still another aspect of the present disclosure may comprise the apparatus for diagnosing a battery according to one aspect of the present disclosure.

A method for diagnosing a battery according to still another aspect of the present disclosure may comprise a profile obtaining step of obtaining a differential profile representing a corresponding relationship between a voltage and a differential capacity of the battery; a target peak determining step of determining a first target peak among a plurality of peaks included in the differential profile; a voltage pattern determining step of determining a voltage pattern of the first target peak based on a voltage profile representing a time series change of a voltage of the first target peak; and a battery diagnosing step of diagnosing a state of the battery according to the determined voltage pattern.

### Advantageous Effects

According to one aspect of the present disclosure, the apparatus for diagnosing a battery has the advantage of being able to diagnose the state of a battery in detail in a non-destructive manner by analyzing the behavior of peaks included in a differential profile.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically illustrating an apparatus for diagnosing a battery according to an embodiment of the present disclosure.
FIG. 2 is a drawing schematically illustrating a differential profile according to an embodiment of the present disclosure.
FIG. 3 is a drawing schematically illustrating a voltage profile according to an embodiment of the present disclosure.
FIG. 4 is a drawing schematically illustrating an embodiment in which a control unit diagnoses a state of a battery according to an embodiment of the present disclosure.
FIG. 5 is a drawing schematically illustrating a differential profile for a first battery according to an embodiment of the present disclosure.
FIG. 6 is a drawing schematically illustrating a differential profile for a second battery according to an embodiment of the present disclosure.
FIG. 7 is a drawing schematically illustrating a differential profile for a third battery according to an embodiment of the present disclosure.
FIG. 8 is a drawing schematically illustrating a battery pack according to another embodiment of the present disclosure.
FIG. 9 is a drawing schematically illustrating a vehicle according to still another embodiment of the present disclosure.
FIG. 10 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

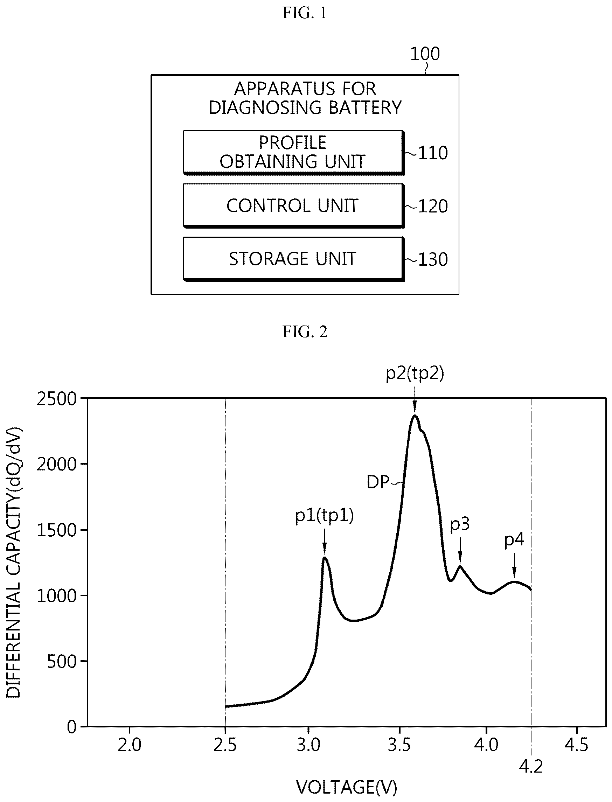

FIG. 1 is a diagram schematically illustrating an apparatus 100 for diagnosing a battery according to an embodiment of the present disclosure.

Referring to FIG. 1, the apparatus 100 for diagnosing a battery may include a profile obtaining unit 110 and a control unit 120.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain a differential profile DP representing a corresponding relationship between the differential capacity and voltage of the battery.

For example, the battery profile is a profile representing the corresponding relationship between voltage (V) and capacity (Q) when the SOC of the battery is charged from a preset charge start SOC or 0% to a preset charge end SOC or 100%. As another example, the battery profile may represent the corresponding relationship between voltage (V) and capacity (Q) when the SOC of the battery is discharged from a preset discharge start SOC or 100% to a preset discharge end SOC or 0%.

Then, by differentiating the battery profile with respect to voltage, a differential profile DP representing the corresponding relationship between differential capacity (dQ/dV) and voltage (V) may be generated.

For example, there is no special limitation on the C-rate in charging or discharging for generating the battery profile. However, preferably, the battery should be charged or discharged at a low rate in order to obtain a more accurate battery profile and differential profile DP. For example, the battery profile may be generated in the process of charging or discharging the battery at 0.05 C.

For example, the profile obtaining unit 110 may directly receive the differential profile DP of the battery from the outside. That is, the profile obtaining unit 110 may obtain the differential profile DP by being connected to the outside by wire and/or wirelessly and receiving the differential profile DP.

As another example, the profile obtaining unit 110 may directly receive the battery profile of the battery from the outside. Then, the profile obtaining unit 110 may differentiate the battery profile with respect to the voltage to generate a differential profile DP. That is, the profile obtaining unit 110 may obtain the differential profile DP by receiving the battery profile through a wired and/or wireless connection to the outside, and directly generating the differential profile DP from the battery profile.

As another example, the profile obtaining unit 110 may receive battery information about the voltage and capacity of the battery. Then, the profile obtaining unit 110 may generate a battery profile based on the received battery information, and generate a differential profile DP based on the generated battery profile. That is, the profile obtaining unit 110 may obtain a differential profile DP by directly generating the differential profile DP based on the battery information.

FIG. 2 is a drawing schematically illustrating a differential profile DP according to an embodiment of the present disclosure. Specifically, the differential profile DP may be expressed as an X-Y graph where the X-axis is set to voltage and the Y-axis is set to differential capacity.

The profile obtaining unit 110 may be connected to communicate with the control unit 120. For example, the profile obtaining unit 110 may be connected to the control unit 120 by wire and/or wirelessly. The profile obtaining unit may transmit the obtained differential profile DP to the control unit 120.

The control unit 120 may be configured to determine a first target peak tp1 among a plurality of peaks included in the differential profile DP.

Specifically, the differential profile DP may include a plurality of peaks. Here, the peak is a point convex upward where the change rate of the differential capacity with respect to the voltage is 0. Here, the slope on the low potential side (the change rate of the differential capacity with respect to the voltage) with respect to the peak is positive, and the slope on the high potential side is negative. Specifically, the peak corresponds to an inflection point of the battery profile and a maximum point of the differential profile DP.

The control unit 120 may determine the peak with the lowest corresponding voltage among the plurality of peaks included in the differential profile DP as a first target peak tp1.

For example, in the embodiment of FIG. 2, the differential profile DP may include a first peak p1, a second peak p2, a third peak p3, and a fourth peak p4. The control unit 120 may determine the first peak p1 having the lowest corresponding voltage as the target peak.

The control unit 120 may be configured to determine the voltage pattern of the first target peak tp1 based on the voltage profile VP representing the time series change of the voltage of the first target peak tp1.

Here, the time series change represents the change of the first target peak tp1 over time. For example, the profile obtaining unit 110 may obtain the first to nth differential profiles DP for the battery. The control unit 120 may determine the first target peak tp1 from each of the first to nth differential profiles DP. Then, the control unit 120 may determine the voltage pattern of the first target peak tp1 based on the time series changes of n first target peaks tp1. Here, the time series changes of n first target peaks tp1 may appear in the voltage profile VP.

Preferably, the control unit 120 may include voltage information of the first target peak tp1 determined from the differential profile DP in the voltage profile VP. That is, the voltage profile VP may be updated whenever the first target peak tp1 is determined.

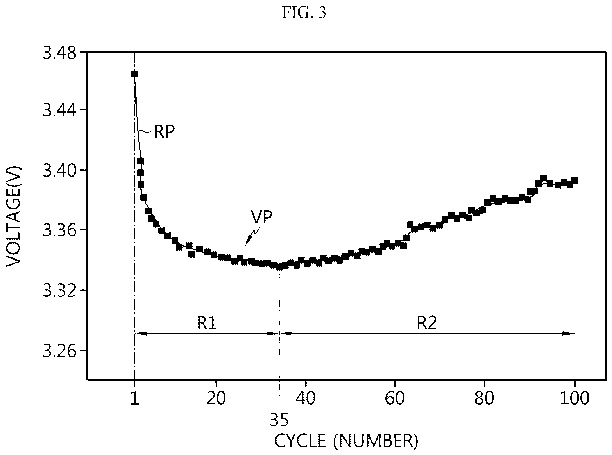

FIG. 3 is a drawing schematically illustrating a voltage profile VP according to an embodiment of the present disclosure. Specifically, the voltage profile VP may be expressed as an X-Y graph in which the X-axis is set to cycle and the Y-axis is set to voltage. Here, the X-axis may be applied without limitation as long as it is a value that can represent the time series change of the first target peak tp1.

The control unit 120 may determine the voltage pattern of the first target peak tp1 based on the voltage change rate in the voltage profile VP. Specifically, the control unit 120 may calculate the voltage change rate based on the instantaneous change rate of voltage over time. Then, the control unit 120 may determine the voltage pattern of the first target peak tp1 based on the calculated voltage change rate.

For example, in the embodiment of FIG. 3, the control unit 120 may determine the voltage pattern of the first target peak tp1 based on the instantaneous change rate of voltage (i.e., the slope of the voltage profile VP) according to the cycle. More specifically, the control unit 120 may determine the voltage increase/decrease pattern of the first target peak tp1 based on the change rate of voltage according to the cycle.

Specifically, the control unit 120 may be configured to determine the voltage pattern as a voltage decrease pattern, a voltage increase pattern, or a voltage maintenance pattern. The voltage decrease pattern is a pattern in which the voltage of the first target peak tp1 gradually decreases as time elapses. The voltage increase pattern is a pattern in which the voltage of the first target peak tp1 gradually increases as time elapses. The voltage maintenance pattern is a pattern in which the voltage of the first target peak tp1 is maintained at a certain level even as time elapses.

Specifically, data included in the voltage profile VP may be discontinuous. For example, in the embodiment of FIG. 3, points indicated by "■" are discontinuous to each other. Therefore, the control unit 120 may apply a regression model to the voltage profile VP to generate a regression profile in order to more accurately calculate the voltage change rate of the first target peak tp1. Preferably, the control unit 120 may generate the regression profile using a polynomial regression model. For example, in the embodiment of FIG. 3, the regression profile indicated by the solid line is generated through the regression model. Since the regression profile is a continuous profile, the instantaneous change rate of the voltage for the cycle may be easily calculated.

If the voltage change rate of the first target peak tp1 in the voltage profile VP is less than a preset first reference value, the control unit 120 may be configured to determine the voltage pattern as a voltage decrease pattern. Here, the first reference value may be preset to a value less than or equal to 0.

If the voltage change rate of the first target peak tp1 exceeds a preset second reference value, the control unit 120 may be configured to determine the voltage pattern as a voltage increase pattern. Here, the second reference value may be preset to a value greater than or equal to 0. That is, the second reference value is a value equal to or greater than the first reference value.

If the voltage change rate of the first target peak tp1 is greater than or equal to the first reference value and less than or equal to the second reference value, the control unit 120 may be configured to determine the voltage pattern as the voltage maintenance pattern.

For example, assume that the first reference value and the second reference value are equal to 0. If the voltage change rate is negative, the control unit 120 may determine the voltage pattern as a voltage decrease pattern. If the voltage change rate is positive, the control unit 120 may determine the voltage pattern as a voltage increase pattern. If the voltage change rate is 0, the control unit 120 may determine the voltage pattern as a voltage maintenance pattern.

As another example, assume that the first reference value is r1, the second reference value is r2, and the condition of "r1 < 0 < r2" is satisfied. If the voltage change rate is less than r1, the control unit 120 may determine the voltage pattern as a voltage decrease pattern. If the voltage change rate exceeds r2, the control unit 120 may determine the voltage pattern as a voltage increase pattern. If the voltage change rate is greater than or equal to r1 and less than or equal to r2, the control unit 120 may determine the voltage pattern as a voltage maintenance pattern.

The control unit 120 may be configured to diagnose the state of the battery according to the determined voltage pattern.

Specifically, the state of the battery corresponding to each voltage pattern may be different from each other. Therefore, the control unit 120 may specifically diagnose the state of the battery based on the voltage pattern of the first target peak tp1.

For example, the state of the battery may be divided into a normal state and a fault state. Here, the normal state includes a capacity expression state in which the capacity of the battery is additionally expressed and a maintenance state in which the battery is in a general state in which it is not degraded. In addition, the fault state includes a positive electrode capacity loss state in which the positive electrode capacity of the battery is lost and an available lithium loss state in which the available lithium of the battery is lost.

Here, the capacity expression state is a state of the battery that may appear depending on the positive electrode active material of the battery. For example, the capacity expression state may appear in a battery that excessively contains lithium as the positive electrode active material. As a specific example, the battery that excessively contains lithium as the positive electrode active material is representatively a battery that contains a lithium manganese oxide. Here, the lithium manganese oxide that excessively contains lithium has a crystal structure in which a layered phase (LiMO₂) and a salt phase (Li₂MnO₃) are mixed. When the salt phase is activated during the charge/discharge process, the capacity is additionally expressed by the oxygen redox reaction, so that a high capacity may be implemented. Specifically, since the oxygen redox reaction causes a manganese redox reaction (Mn redox reaction), the capacity of the battery may be additionally expressed.

In addition, the positive electrode capacity loss refers to a degradation state of a battery in which the available capacity of the battery is reduced due to loss of the positive electrode of the battery. Specifically, the positive electrode capacity loss state refers to a state in which the available positive electrode area itself is reduced due to physical and/or chemical damage to the positive electrode of the battery.

Also, the available lithium loss refers to a degradation state of the battery in which the available lithium ions of the battery are reduced. Specifically, the available lithium loss state refers to a state in which lithium is deposited on the surface of the negative electrode (Li-plating). When lithium is deposited on the surface of the negative electrode, it causes side reactions with the electrolyte and changes in the kinetic balance of the battery, which causes battery degradation. In addition, since lithium metal is deposited on the surface of the negative electrode, an internal short circuit of the battery may occur, and there is a risk of ignition and explosion due to the internal short circuit.

Finally, the maintenance state refers to a general state in which the capacity of the battery is neither expressed nor degraded.

The apparatus 100 for diagnosing a battery according to an embodiment of the present disclosure has an advantage in that it may non-destructively diagnose the state of the battery in detail by analyzing the behavior of peaks included in the differential profile DP. In particular, since the apparatus 100 for diagnosing a battery may diagnose the state of the battery as a capacity expression state, a maintenance state, a positive electrode capacity loss state, or an available lithium loss state, the current state of the battery may be more accurately identified.

Meanwhile, the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

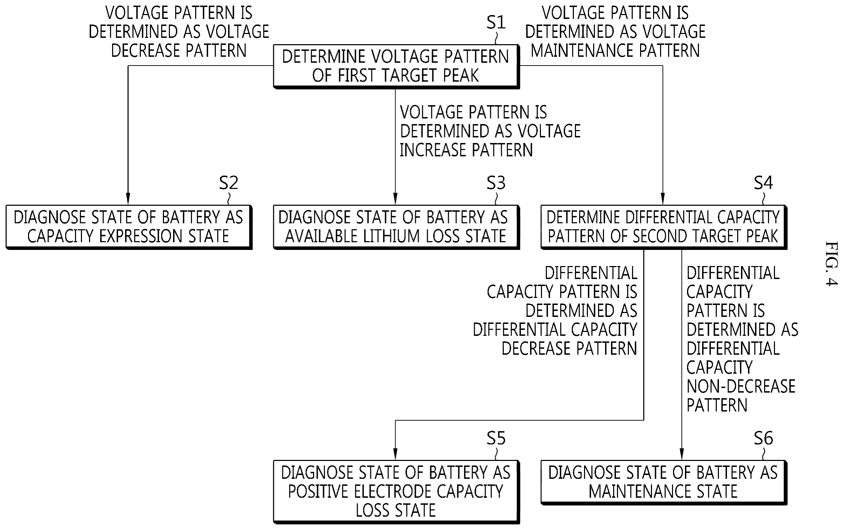

Hereinafter, with reference to FIG. 4, an embodiment in which the control unit 120 diagnoses the state of a battery is described in more detail.

FIG. 4 is a drawing schematically illustrating an embodiment in which the control unit 120 diagnoses a state of a battery according to an embodiment of the present disclosure.

In step S1, the control unit 120 may determine the voltage pattern of the first target peak tp1. If the voltage pattern is determined as a voltage decrease pattern, step S2 is performed, if the voltage pattern is determined as a voltage increase pattern, step S3 is performed, and if the voltage pattern is determined as a voltage maintenance pattern, step S4 is performed.

In step S2, the control unit 120 may diagnose the state of the battery as a capacity expression state. That is, if the voltage pattern is determined as a voltage decrease pattern, the control unit 120 may be configured to diagnose the state of the battery as a capacity expression state.

In step S3, the control unit 120 may diagnose the state of the battery as an available lithium loss state. That is, if the voltage pattern is determined as a voltage increase pattern, the control unit 120 may be configured to diagnose the state of the battery as an available lithium loss state.

Referring to FIG. 4, if the voltage pattern of the first target peak tp1 is a voltage decrease pattern or a voltage increase pattern, the control unit 120 may immediately diagnose the state of the battery. However, if the voltage pattern of the first target peak tp1 is a voltage maintenance pattern, the control unit 120 may diagnose the state of the battery by further considering the second target peak tp2.

In step S4, the control unit 120 may determine the differential capacity pattern of the second target peak tp2. In step S4, if the differential capacity pattern is determined as the differential capacity decrease pattern, step S5 is performed, and if the differential capacity pattern is determined as the differential capacity non-decrease pattern, step S6 is performed. That is, if the voltage pattern is determined as the voltage maintenance pattern, the control unit 120 may be configured to diagnose the state of the battery according to the determined differential capacity pattern.

Specifically, if the voltage pattern is determined as the voltage maintenance pattern, the control unit 120 may be configured to determine the second target peak tp2 among the plurality of peaks included in the differential profile DP. The second target peak tp2 is a peak having the largest corresponding differential capacity among the plurality of peaks included in the differential profile DP. For example, in the embodiment of FIG. 2, the second peak p2 may be determined as the second target peak tp2.

The control unit 120 may be configured to determine the differential capacity pattern of the second target peak tp2 based on the differential capacity profile representing the time series change of the differential capacity of the second target peak tp2. For example, in the embodiment of FIG. 3, a profile in which the voltage of the first target peak tp1 is replaced with the differential capacity of the second target peak tp2 is the differential capacity profile. That is, the differential capacity profile may be expressed as an X-Y graph in which the X-axis is set as a cycle and the Y-axis is set as the differential capacity. Here, any value that may represent the time series change of the second target peak tp2 can be applied to the X-axis without limitation.

The control unit 120 may be configured to determine the differential capacity pattern as a differential capacity decrease pattern or a differential capacity non-decrease pattern. Here, the differential capacity non-decrease pattern means a pattern in which the differential capacity increases or is maintained.

If the differential capacity change rate of the second target peak tp2 in the differential capacity profile is less than a preset third reference value, the control unit 120 may be configured to determine the differential capacity pattern as a differential capacity decrease pattern. Conversely, if the differential capacity change rate of the second target peak tp2 in the differential capacity profile is greater than or equal to the third reference value, the control unit 120 may be configured to determine the differential capacity pattern as a differential capacity non-decrease pattern.

Preferably, the third reference value may be set to a value less than or equal to 0. The third reference value may be set to an appropriate value that may distinguish the differential capacity pattern of the second target peak tp2 into a differential capacity decrease pattern and a non-decrease pattern based on experimentally or theoretically calculated results.

For example, assume that the third reference value is set to 0. If the differential capacity change rate is negative, the control unit 120 may determine the differential capacity pattern as a differential capacity decrease pattern. Conversely, if the differential capacity change rate is 0 or positive, the control unit 120 may determine the differential capacity pattern as a differential capacity non-decrease pattern.

As another example, assume that the third reference value is set to r3 and the condition of "r3 < 0" is satisfied. If the differential capacity change rate is less than r3, the control unit 120 may determine the differential capacity pattern as the differential capacity decrease pattern. Conversely, if the differential capacity change rate is greater than or equal to r3, the control unit 120 may determine the differential capacity pattern as the differential capacity non-decrease pattern.

Similar to the embodiment of FIG. 3, the control unit 120 may generate a regression profile by applying a regression model to the differential capacity profile in order to more accurately calculate the differential capacity change rate of the second target peak tp2. In addition, the control unit 120 may calculate the instantaneous change rate for the differential capacity of the second target peak tp2 to calculate the differential capacity change rate. In addition, the control unit 120 may compare the calculated differential capacity change rate with a preset third reference value to determine the differential capacity pattern as a differential capacity decrease pattern or a differential capacity non-decrease pattern.

In step S5, the control unit 120 may diagnose the state of the battery as a positive electrode capacity loss state. That is, if the differential capacity pattern is determined as a differential capacity decrease pattern, the control unit 120 may be configured to diagnose the state of the battery as a positive electrode capacity loss state.

In step S6, the control unit 120 may diagnose the state of the battery as a maintenance state. That is, if the differential capacity pattern is determined as a differential capacity non-decrease pattern, the control unit 120 may be configured to diagnose the state of the battery as a maintenance state.

The apparatus 100 for diagnosing a battery according to an embodiment of the present disclosure may diagnose the state of a battery in detail based on the voltage pattern of the first target peak tp1 and the differential capacity pattern of the second target peak tp2. Therefore, the apparatus 100 for diagnosing a battery has an advantage in that it may diagnose the current state of a battery more accurately and in detail.

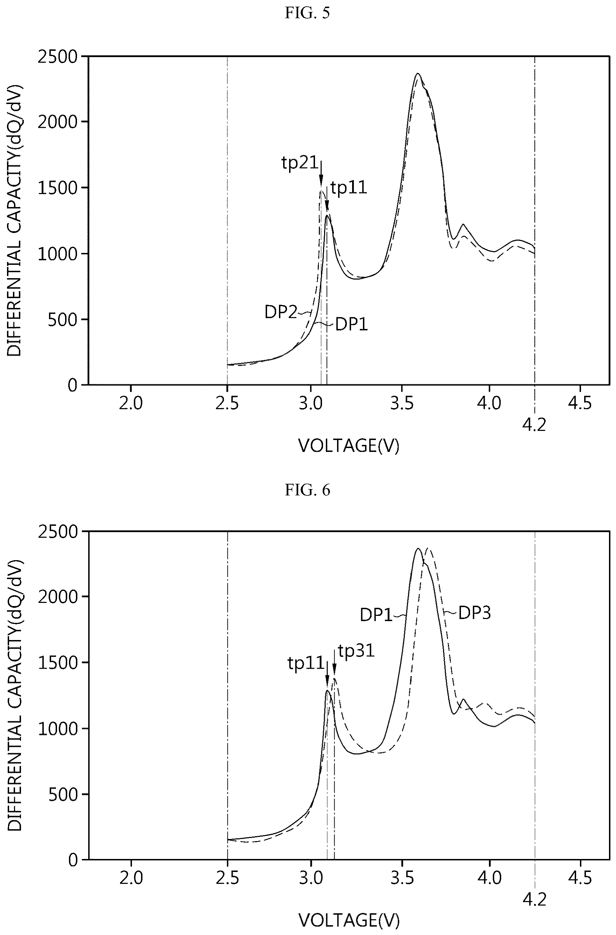

FIG. 5 is a drawing schematically illustrating a differential profile DP1, DP2 for a first battery according to an embodiment of the present disclosure. Specifically, in the embodiment of FIG. 5, the first differential profile DP1 is a differential profile of the BOL (beginning of life) state of the first battery, and the second differential profile DP2 is a differential profile of the MOL (middle of life) state of the first battery. That is, in terms of timing, the first differential profile DP1 precedes and the second differential profile DP2 follows.

Specifically, the first battery is a battery in a capacity expression state. That is, the first battery is a state in which capacity is additionally expressed by a redox reaction.

Referring to FIG. 5, the voltage of the first target peak tp21 of the second differential profile DP2 is lower than the voltage of the first target peak tp11 of the first differential profile DP1. That is, in the capacity expression state, the voltage of the first target peak tp21 may shift to the low potential side. Accordingly, if the voltage pattern of the first target peak tp21 is a voltage decrease pattern, the control unit 120 may diagnose the state of the battery as a capacity expression state.

FIG. 6 is a drawing schematically illustrating a differential profile DP1, DP3 for a second battery according to an embodiment of the present disclosure. Specifically, in the embodiment of FIG. 6, the first differential profile DP1 is a differential profile of the BOL state of the second battery, and the third differential profile DP3 is a differential profile of the MOL state of the second battery. That is, in terms of timing, the first differential profile DP1 precedes and the third differential profile DP3 follows.

Specifically, the second battery is a battery in an available lithium loss state. That is, in this state, lithium metal is deposited on the negative electrode surface of the second battery, and the amount of lithium used in charge and discharge is reduced.

Referring to FIG. 6, the voltage of the first target peak tp31 of the third differential profile DP3 is higher than the voltage of the first target peak tp11 of the first differential profile DP1. That is, in the available lithium loss state, the voltage of the first target peak tp31 may shift to the high potential side. Accordingly, if the voltage pattern of the first target peak tp31 is a voltage increase pattern, the control unit 120 may diagnose the state of the battery as an available lithium loss state.

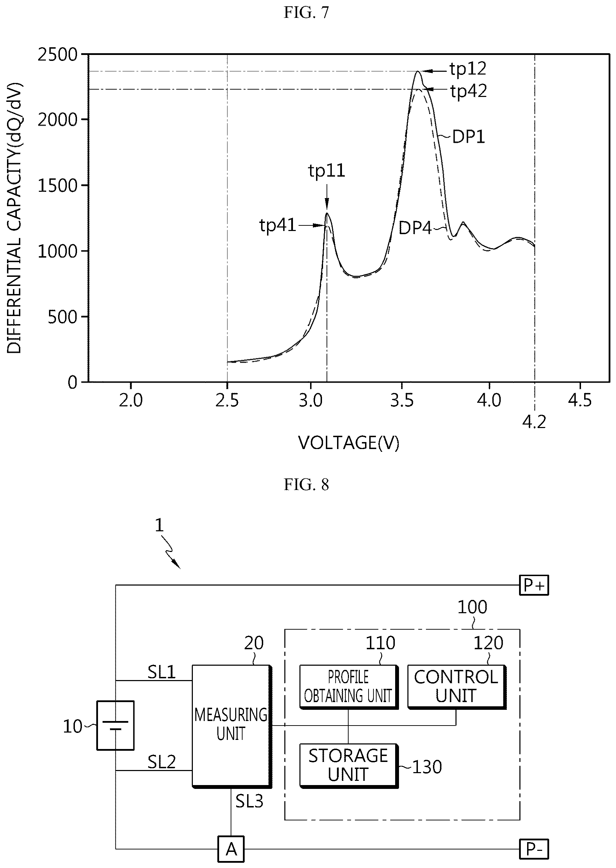

FIG. 7 is a drawing schematically illustrating a differential profile DP1, DP4 for a third battery according to an embodiment of the present disclosure. Specifically, in the embodiment of FIG. 7, the first differential profile DP1 is a differential profile of the BOL state of the third battery, and the fourth differential profile DP4 is a differential profile of the MOL state of the third battery. That is, in terms of timing, the first differential profile DP1 precedes and the fourth differential profile DP4 follows.

Specifically, the third battery is a battery in a positive electrode capacity loss state. That is, the third battery is in a state where the area of the positive electrode that can be used in charging and discharging is lost, and the positive electrode capacity is reduced.

Referring to FIG. 7, the voltage of the first target peak tp41 of the fourth differential profile DP4 matches the voltage of the first target peak tp11 of the first differential profile DP1. In addition, the differential capacity of the second target peak tp42 of the fourth differential profile DP4 is lower than the differential capacity of the second target peak tp12 of the first differential profile DP1. That is, in the positive electrode capacity loss state, the change in the voltage of the first target peak tp11, tp41 is minimal, but the differential capacity of the second target peak tp12, tp42 may decrease by a certain level or more. Therefore, if the voltage pattern of the first target peak tp41 is a voltage maintenance pattern and the differential capacity pattern of the second target peak tp42 is a differential capacity decrease pattern, the control unit 120 may diagnose the state of the battery as a positive electrode capacity loss state.

The control unit 120 may be configured to divide the voltage profile VP into a plurality of sections based on time points at which the voltage pattern changes.

Specifically, the control unit 120 may divide the cycle section of the voltage profile VP into a plurality of sections. Preferably, the control unit 120 may divide the voltage profile VP into a plurality of sections based on a time point at which the voltage pattern changes.

For example, the voltage profile VP may be divided into a plurality of sections based on the time point at which the voltage pattern changes from a voltage decrease pattern to a voltage increase pattern or a voltage maintenance pattern.

As another example, the voltage profile VP may be divided into a plurality of sections based on the time point at which the voltage pattern changes from a voltage increase pattern to a voltage decrease pattern or a voltage maintenance pattern.

As still another example, the voltage profile VP may be divided into a plurality of sections based on the time point at which the voltage pattern changes from a voltage maintenance pattern to a voltage decrease pattern or a voltage increase pattern.

In the embodiment of FIG. 3, the control unit 120 may distinguish the voltage profile VP based on the 35th cycle. The first section R1 includes the first to 35th cycles, and the second section R2 includes the 36th to 100th cycles.

The control unit 120 may be configured to diagnose the state of the battery for each of the plurality of sections.

Specifically, since each of the plurality of sections has the same voltage pattern, the control unit 120 may diagnose the state of each section for the battery.

For example, in the embodiment of FIG. 3, the voltage pattern corresponding to the first section R1 is a voltage decrease pattern. Accordingly, the control unit 120 may diagnose the state of the battery as a capacity expression state in the first to 35th cycles.

As another example, in the embodiment of FIG. 3, the voltage pattern corresponding to the second section R2 is a voltage increase pattern. Accordingly, the control unit 120 may diagnose the state of the battery as an available lithium loss state in the 36th to 100th cycles.

As still another example, if the voltage pattern of any section is a voltage maintenance pattern, the control unit 120 may diagnose the state of the battery as a positive electrode capacity loss state or a maintenance state by considering the differential capacity pattern of the second target peak tp2 in the corresponding section.

The apparatus 100 for diagnosing a battery according to an embodiment of the present disclosure has an advantage in that it may track and diagnose the state of a battery. Accordingly, according to the apparatus 100 for diagnosing a battery, since the time point at which the state of the battery changes may be specified, appropriate measures such as charge/discharge control or change of usage conditions may be performed by considering the history of state changes of the battery.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the profile obtaining unit 110, the control unit 120 and the storage unit 130 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

FIG. 8 is a diagram showing a battery pack 1 according to another embodiment of the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

The measuring unit 20 may be connected to the first sensing line SL1, the second sensing line SL2, and the third sensing line SL3. Specifically, the measuring unit 20 may be connected to the positive electrode terminal of the battery 10 through the first sensing line SL1 and connected to the negative electrode terminal of the battery 10 through the second sensing line SL2. The measuring unit 20 may measure the voltage of the battery 10 based on the voltage measured at each of the first sensing line SL1 and the second sensing line SL2.

Also, the measuring unit 20 may be connected to the current measuring unit A through the third sensing line SL3. For example, the current measuring unit A may be an ammeter or a shunt resistor capable of measuring the charging current and the discharging current of the battery 10. The measuring unit 20 may measure the charging current of the battery 10 through the third sensing line SL3 to calculate the charge amount. In addition, the measuring unit 20 may measure the discharging current of the battery 10 through the third sensing line SL3 to calculate the discharge amount.

For example, the measuring unit 20 may transmit battery information about voltage and current of the battery 10 to the apparatus 100 for diagnosing a battery. The profile obtaining unit 110 may receive the battery information from the measuring unit 20 and generate a battery profile and a differential profile.

As another example, the measuring unit 20 may generate a battery profile representing a corresponding relationship between the voltage and capacity of the battery 10, and transmit the generated battery profile to the apparatus 100 for diagnosing a battery. The profile obtaining unit 110 may receive the battery profile from the measuring unit 20, and generate a differential profile based on the received battery profile.

As still another example, the measuring unit 20 may generate a differential profile based on the battery information and transmit the generated differential profile to the apparatus 100 for diagnosing a battery. The profile obtaining unit 110 may receive the differential profile from the measuring unit 20.

An external device may be connected to the positive electrode terminal P+ and the negative electrode terminal P- of the battery pack 1. For example, the external device may be a charging device or a load. In addition, the positive electrode terminal of the battery 10, the positive electrode terminal P+ of the battery pack 1, the external device, the negative electrode terminal P- of the battery pack 1, and the negative electrode terminal of the battery 10 may be electrically connected.

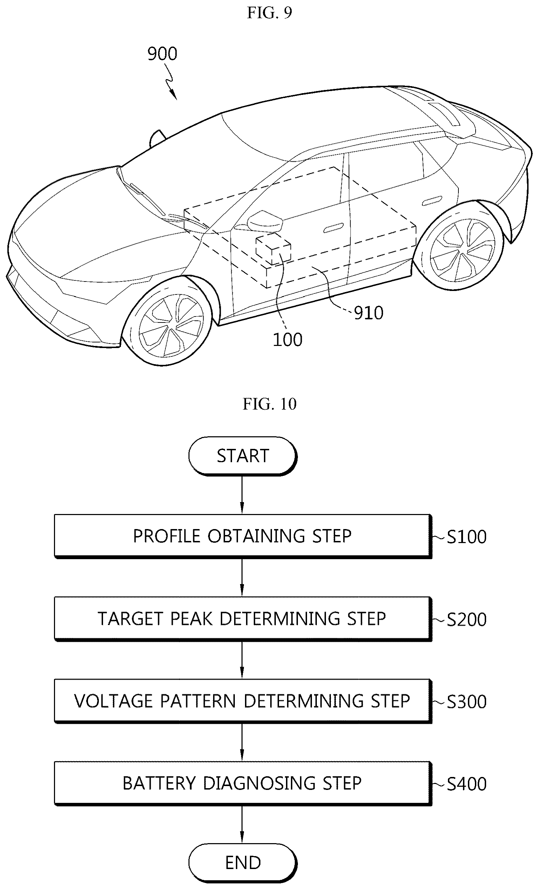

FIG. 9 is a drawing schematically illustrating a vehicle 900 according to still another embodiment of the present disclosure.

Referring to FIG. 9, the battery pack according to an embodiment of the present disclosure may be included in a vehicle 900, such as an electric vehicle (EV) or a hybrid vehicle (HV). In addition, the battery pack 910 may drive the vehicle 900 by supplying power to a motor through an inverter provided in the vehicle 900. Here, the battery pack 910 may include the apparatus 100 for diagnosing a battery. That is, the vehicle 900 may include the apparatus 100 for diagnosing a battery. In this case, the apparatus 100 for diagnosing a battery may be an onboard device included in the vehicle 900.

FIG. 10 is a diagram schematically showing a method for diagnosing a battery according to still another embodiment of the present disclosure.

Referring to FIG. 10, the method for diagnosing a battery may include a profile obtaining step (S100), a target peak determining step (S200), a voltage pattern determining step (S300) and a battery diagnosing step (S400).

Preferably, each step of the method for diagnosing a battery may be performed by the apparatus 100 for diagnosing a battery. Hereinafter, for convenience of explanation, content that overlaps with the content described above will be omitted or briefly described.

The profile obtaining step (S100) is a step of obtaining a differential profile DP representing a corresponding relationship between a voltage and a differential capacity of a battery, and may be performed by the profile obtaining unit 110.

For example, the profile obtaining unit 110 may directly receive the differential profile DP of the battery from the outside. That is, the profile obtaining unit 110 may obtain the differential profile DP by being connected to the outside by wire and/or wirelessly and receiving the differential profile DP.

As another example, the profile obtaining unit 110 may directly receive the battery profile of the battery from the outside. Then, the profile obtaining unit 110 may differentiate the battery profile with respect to the voltage to generate a differential profile DP. That is, the profile obtaining unit 110 may obtain the differential profile DP by receiving the battery profile through a wired and/or wireless connection to the outside, and directly generating the differential profile DP from the battery profile.

As still another example, the profile obtaining unit 110 may receive battery information about the voltage and capacity of the battery. Then, the profile obtaining unit 110 may generate a battery profile based on the received battery information, and generate a differential profile DP based on the generated battery profile. That is, the profile obtaining unit 110 may obtain a differential profile DP by directly generating the differential profile DP based on the battery information.

The target peak determining step (S200) is a step of determining a first target peak tp1 among a plurality of peaks included in the differential profile DP, and may be performed by the control unit 120.

The control unit 120 may determine a peak with the lowest corresponding voltage among the plurality of peaks included in the differential profile DP as the first target peak tp1.

The voltage pattern determining step (S300) is a step of determining a voltage pattern of the first target peak tp1 based on the voltage profile VP representing a time series change of the first target peak tp1, and may be performed by the control unit 120.

Specifically, the control unit 120 may be configured to determine the voltage pattern as a voltage decrease pattern, a voltage increase pattern, or a voltage maintenance pattern.

If the voltage change rate of the first target peak tp1 in the voltage profile VP is less than a preset first reference value, the control unit 120 may be configured to determine the voltage pattern as a voltage decrease pattern. Here, the first reference value may be preset to a value less than or equal to 0.

If the voltage change rate of the first target peak tp1 exceeds a preset second reference value, the control unit 120 may be configured to determine the voltage pattern as a voltage increase pattern. Here, the second reference value may be preset to a value greater than or equal to 0. That is, the second reference value is a value equal to or greater than the first reference value.

If the voltage change rate of the first target peak tp1 is greater than or equal to the first reference value and less than or equal to the second reference value, the control unit 120 may be configured to determine the voltage pattern as the voltage maintenance pattern.

Here, the first reference value and the second reference value may be set to appropriate values that may distinguish the voltage pattern of the first target peak tp1 into a voltage decrease pattern, a voltage increase pattern, or a voltage maintenance pattern based on experimentally or theoretically calculated results.

The battery diagnosing step (S400) is a step for diagnosing the state of the battery according to the determined voltage pattern, and may be performed by the control unit 120.

Referring to FIG. 4, if the voltage pattern of the first target peak tp1 is a voltage decrease pattern or a voltage increase pattern, the control unit 120 may immediately diagnose the state of the battery. However, if the voltage of the first target peak tp1 is a voltage maintenance pattern, the control unit 120 may diagnose the state of the battery by further considering the second target peak tp2.

For example, if the voltage pattern is determined as a voltage decrease pattern, the control unit 120 may be configured to diagnose the state of the battery as a capacity expression state.

As another example, if the voltage pattern is determined as a voltage increase pattern, the control unit 120 may be configured to diagnose the state of the battery as an available lithium loss state.

As still another example, if the voltage pattern is determined as a voltage maintenance pattern and the differential capacity pattern is determined as a differential capacity decrease pattern, the control unit 120 may be configured to diagnose the state of the battery as a positive electrode capacity loss state.

As still another example, if the voltage pattern is determined as a voltage maintenance pattern and the differential capacity pattern is determined as a differential capacity non-decrease pattern, the control unit 120 may be configured to diagnose the state of the battery as a maintenance state.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference symbols)

1: battery pack
10: battery
20: measuring unit
100: apparatus for diagnosing a battery
110: profile obtaining unit
120: control unit
130: storage unit
900: vehicle
910: battery pack

## Claims

1. An apparatus for diagnosing a battery, comprising:
a profile obtaining unit configured to obtain a differential profile representing a corresponding relationship between a voltage and a differential capacity of the battery; and
a control unit configured to determine a first target peak among a plurality of peaks included in the differential profile, determine a voltage pattern of the first target peak based on a voltage profile representing a time series change of a voltage of the first target peak, and diagnose a state of the battery according to the determined voltage pattern.

2. The apparatus for diagnosing a battery according to claim 1,
wherein the control unit is configured to determine the voltage pattern as a voltage decrease pattern, a voltage increase pattern, or a voltage maintenance pattern.

3. The apparatus for diagnosing a battery according to claim 2,
wherein the control unit is configured to:
determine the voltage pattern as the voltage decrease pattern when a voltage change rate of the first target peak is less than a preset first reference value in the voltage profile,
determine the voltage pattern as the voltage increase pattern when the voltage change rate of the first target peak exceeds a preset second reference value, and
determine the voltage pattern as the voltage maintenance pattern when the voltage change rate of the first target peak is greater than or equal to the first reference value and less than or equal to the second reference value.

4. The apparatus for diagnosing a battery according to claim 2,
wherein the control unit is configured to diagnose the state of the battery as a capacity expression state when the voltage pattern is determined as the voltage decrease pattern.

5. The apparatus for diagnosing a battery according to claim 2,
wherein the control unit is configured to diagnose the state of the battery as an available lithium loss state when the voltage pattern is determined as the voltage increase pattern.

6. The apparatus for diagnosing a battery according to claim 2,
wherein when the voltage pattern is determined as the voltage maintenance pattern, the control unit is configured to determine a second target peak among the plurality of peaks included in the differential profile, determine a differential capacity pattern of the second target peak based on a differential capacity profile representing a time series change in a differential capacity of the second target peak, and diagnose the state of the battery according to the determined differential capacity pattern.

7. The apparatus for diagnosing a battery according to claim 6,
wherein the control unit is configured to determine the differential capacity pattern as a differential capacity decrease pattern or a differential capacity non-decrease pattern.

8. The apparatus for diagnosing a battery according to claim 7,
wherein the control unit is configured to:
determine the differential capacity pattern as the differential capacity decrease pattern when a differential capacity change rate of the second target peak in the differential capacity profile is less than a preset third reference value, and
determine the differential capacity pattern as the differential capacity non-decrease pattern when the differential capacity change rate of the second target peak in the differential capacity profile is greater than or equal to the third reference value.

9. The apparatus for diagnosing a battery according to claim 7,
wherein the control unit is configured to diagnose the state of the battery as a positive electrode capacity loss state when the differential capacity pattern is determined as the differential capacity decrease pattern.

10. The apparatus for diagnosing a battery according to claim 7,
wherein the control unit is configured to diagnose the state of the battery as a maintenance state when the differential capacity pattern is determined as the differential capacity non-decrease pattern.

11. The apparatus for diagnosing a battery according to claim 2,
wherein the control unit is configured to divide the voltage profile into a plurality of sections based on a time point when the voltage pattern changes, and to diagnose the state of the battery for each of the plurality of sections.

12. A battery pack, comprising the apparatus for diagnosing a battery according to any one of claims 1 to 11.

13. A vehicle, comprising the apparatus for diagnosing a battery according to any one of claims 1 to 11.

14. A method for diagnosing a battery, comprising:
a profile obtaining step of obtaining a differential profile representing a corresponding relationship between a voltage and a differential capacity of the battery;
a target peak determining step of determining a first target peak among a plurality of peaks included in the differential profile;
a voltage pattern determining step of determining a voltage pattern of the first target peak based on a voltage profile representing a time series change of a voltage of the first target peak; and
a battery diagnosing step of diagnosing a state of the battery according to the determined voltage pattern.
